# EUROPEAN PATENT APPLICATION

(11) **EP 1 278 200 A2**
(43) Date of publication of application: **22.01.2003**
(21) Application number: 02250788.3
(22) Date of filing: 06.02.2002
(51) Int. Cl.: G11C 16/10, G11C 29/00

(54) **Semiconductor memory and method of driving semiconductor memory**

(30) Priority: 18.07.2001 JP 2001217660
(71) Applicant: FUJITSU LIMITED, Kawasaki-shi, Kanagawa 211-8588 (JP)
(72) Inventor: Kawamura, Shoichi, c/o Fujitsu Limited, Kawasaki-shi, Kanagawa 211-8588 (JP)
(74) Representative: Hitching, Peter Matthew

(57) **Abstract**

A semiconductor memory is disclosed, the memory comprising memory cells each comprising a transistor having a control gate and a floating gate. During a period in which data write to a memory cell is performed, a positive voltage (a voltage substantially 1/2 the power supply voltage or more, and lower than the power supply voltage) is supplied to a memory cell source line (ARVSS) for supplying a reference potential to the memory cell. Even if a bit line (BL1-BL4) and the memory cell source line (ARVSS) are short-circuited, the potential of a node in a latch buffer unit is maintained at least during a period in which this node and the bit line are electrically connected. Since this makes it possible to determine that a program operation is normally performed and to complete a program verify operation, a defect caused by the short circuit between the bit line (BL1-BL4) and the memory cell source line (ARVSS) can be repaired by using a redundancy circuit.

## Description

The present invention relates to a semiconductor memory and a method of driving the semiconductor memory and, more particularly, to a semiconductor memory and a method of driving the semiconductor memory suitably applicable to a NAND flash memory.

This application is based upon and claims priority of Japanese Patent Application No. 2001-217660, filed on July 18, 2001, the contents being incorporated herein by reference.

In conventional NAND flash memories, a memory cell threshold voltage Vₜₕ is controlled, when data is written in or erased from a memory cell, by performing a verify operation for checking whether this memory cell threshold voltage Vₜₕ has a sufficient read margin with respect to a read determination level (voltage).

This verify operation of a NAND flash memory is performed for memory cells sharing the same word line and connected to a plurality of bit lines (approximately 4,000 lines) of the NAND flash memory at the same time. If no sufficient read margin is obtained in this verify operation, data write or erase to the memory cell is performed again, and the verify operation is performed repeatedly until it is determined that all the bit lines have a sufficient read margin.

Also, in a block composed of a plurality of memory cells of a NAND flash memory, redundancy circuits comprising redundancy memory cells which are the same as memory cells of NAND flash memory sharing a word line is formed. If a defect such as a short circuit of adjacent bit lines occurs in the fabrication process of this NAND flash memory, several bit lines including the defective bit lines, as one unit, is replaced with the redundancy circuit.

In the NAND flash memory as described above, however, the verify operation is performed for memory cells sharing the same word line and connected to a plurality of bit lines at the same time. That is, this verify operation is performed for memory cells connected to bit lines of the redundancy circuit and to defective bit lines as well. Accordingly, if a defect occurs owing to a short circuit of adjacent bit lines, data write to memory cells connected to the defective bit lines is inhibited to prevent fluctuations in the potential of these defective bit lines, in order to make the state equal to the state in which the memory cell threshold voltage Vₜₕ has a sufficient read margin, thereby completing the verify operation.

Unfortunately, if a defect is caused by a short circuit between a bit line and a line (to be referred to as a "memory cell source line" hereinafter) which supplies a reference potential (source potential) to memory cells, the potential of the defective bit line may fluctuate owing to this memory cell source line, even when data write to memory cells connected to the defective bit line is inhibited to make the state equal to the state in which the memory cell threshold voltage Vₜₕ has a sufficient read margin. This makes the verify operation impossible to complete. That is, if a defect is caused by a short circuit between a bit line and a memory cell source line, this defect cannot be repaired even with the use of the redundancy circuit.

It is desirable to be able to repair a defect caused by a short circuit between a bit line and a line for supplying a reference potential to memory cells.

A semiconductor memory of the present invention comprises a memory cell comprising a transistor having a control gate and a floating gate to store data, and a line for supplying a reference potential to the memory cell. The potential of the line for supplying the reference potential to the memory cell is set at a positive potential, during a period in which data write to the memory cell is performed.

In the present invention configured as above, even if a bit line for inputting and outputting data to and from the memory cell and the line (memory cell source line) for supplying the reference potential to this memory cell are short-circuited, the fluctuations in the potential of this bit line during data write to the memory cell is suppressed such that the data in a latch circuit connected to it can be held, thereby preventing the inversion of data in the latch circuit. Accordingly, a verify operation performed after the data write can be completed.

Preferred features of the present invention will now be described, purely by way of example, with reference to the accompanying drawings, in which:-
Fig. 1A is a view showing the arrangement of a memory portion of a NAND flash memory to which a semiconductor memory according to an embodiment of the present invention is applied;
Fig. 1B is a sectional view taken along a line I - I in Fig. 1A;
Fig. 2 is a view showing an equivalent circuit of the memory portion of the NAND flash memory;
Fig. 3 is a view showing the arrangement of a memory cell array of the NAND flash memory;
Fig. 4 is a block diagram showing the arrangement of a page buffer;
Fig. 5A is a schematic view showing the section of a memory cell transistor and the state of data storage (the data value is "1");
Fig. 5B is a schematic view showing the section of the memory cell transistor and the state of data storage (the data value is "0");
Fig. 6A is a timing chart of a read operation (data value "1" read) of the NAND flash memory;
Fig. 6B is a timing chart of a read operation (data value "0" read) of the NAND flash memory;
Fig. 7A is a timing chart of a program operation (during data write) of the NAND flash memory;
Fig. 7B is a timing chart of a program operation (when data write is inhibited) of the NAND flash memory;
Fig. 8A is a timing chart of a program verify operation (when data write is complete) of the NAND flash memory;
Fig. 8B is a timing chart of a program verify operation (when data write is insufficient) of the NAND flash memory;
Fig. 9A is a timing chart of a program operation (when data write is inhibited) of a conventional NAND flash memory in case of short circuit between the bit line and memory cell source line;
Fig. 9B is a timing chart of a program verify operation of the conventional NAND flash memory in case of short circuit between the bit line and memory cell source line;
Fig. 10A is a timing chart of an erase verify operation (when data erase is complete) of the NAND flash memory;
Fig. 10B is a timing chart of an erase verify operation (when data erase is insufficient) of the NAND flash memory; and
Fig. 11 is a view showing examples of applied voltages in different operations of the NAND flash memory.

### (Arrangement of flash memory)

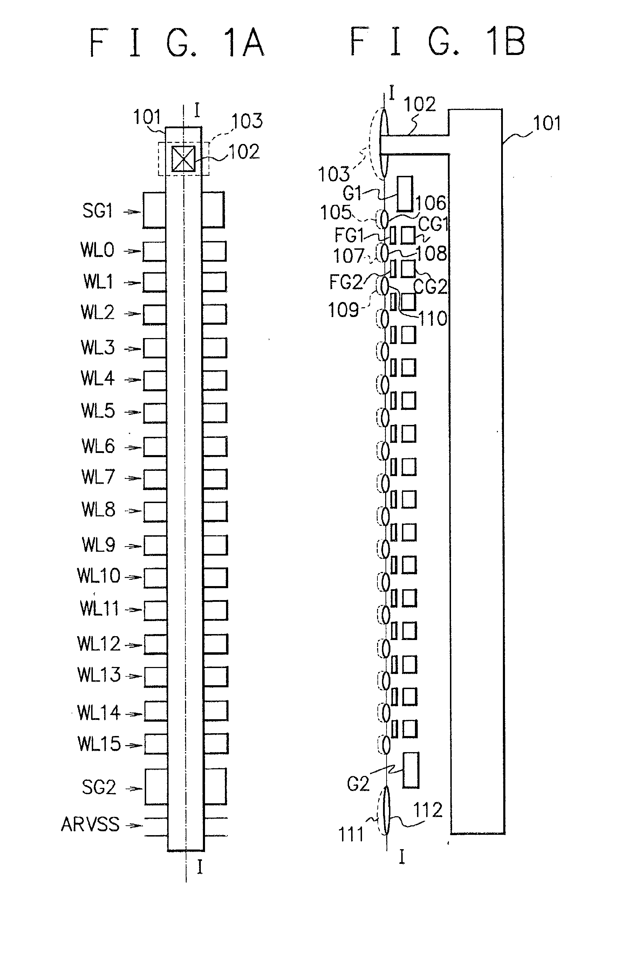

Fig. 1A is a view showing the arrangement of a memory portion of a NAND flash memory to which a semiconductor memory according to the embodiment of the present invention is applied.

In Fig. 1A, reference numeral 101 denotes a bit line made of a metal and connected, by a contact 102, to a semiconductor substrate on which memory cell transistors are formed; and 103, a diffusion layer formed on the semiconductor substrate to connect the bit line 101.

Reference symbols SG1 and SG2 denote control signal lines for controlling first and second select gate transistors, respectively; WLn (n is a suffix, n = integer from 0 to 15), a word line for selecting a memory cell; and ARVSS, a line (to be referred to as a "memory cell source line" hereinafter) which supplies a reference potential (the source potential of a memory cell transistor) to memory cells.

Fig. 1B is a sectional view taken along a line I - I in Fig. 1A.

In Fig. 1B, reference symbols G1 and G2 denote the gates of the first and second select gate transistors, respectively. Control voltages are supplied to these gates G1 and G2 through the control signal lines SG1 and SG2, respectively, shown in Fig. 1A.

Reference numerals 105, 107, and 109 denote diffusion layers formed on the semiconductor substrate to serve as the drain and source of each memory cell transistor; and 106, 108, and 110, oxide films. Reference symbols CG1 and CG2 denote the control gates of each memory cell transistor, to which a voltage is supplied from the word line WLn shown in Fig. 1A; and FG1 and FG2, the floating gates of each memory cell transistor.

Reference numeral 111 denotes a diffusion layer for forming the memory cell source line; and 112, an oxide film.

Referring to Fig. 1B, the first select gate transistor is made up of the gate G1, the diffusion layer 103 as a drain, and the diffusion layer 105 as a source. Also, one memory cell transistor is composed of the control gate CG1, the floating gate FG1, the diffusion layer 105 as a drain, and the diffusion layer 107 as a source. Likewise, another memory cell transistor is composed of the control gate CG2, the floating gate FG2, the diffusion layer 107 as a drain, and the diffusion layer 109 as a source. That is, in this NAND flash memory, the source of the first select gate transistor, the drains and sources of the memory cell transistors, and the drain of the second select gate transistor share diffusion layers with adjacent transistors.

When the memory cell source line ARVSS is formed only with the diffusion layer 111, the resistance of this memory cell source line ARVSS increases. Although not shown in Figs. 1A and 1B, therefore, a memory cell source line ARVSS made of a metal is formed to run parallel to a plurality of bit lines 101, as one unit, and connected to a diffusion layer on the semiconductor substrate by a contact, similar to the bit lines 101.

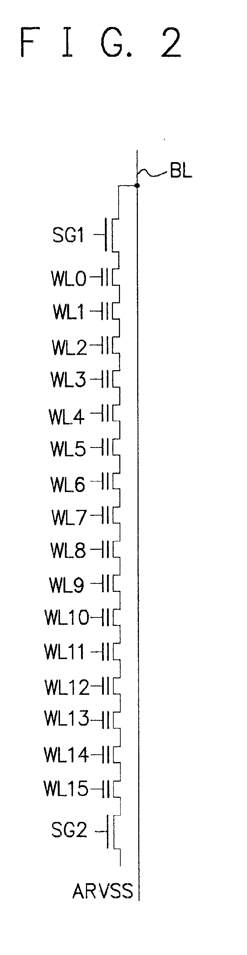

Fig. 2 is a view showing an equivalent circuit of the memory portion of the NAND flash memory having the arrangement shown in Figs. 1A and 1B.

As shown in Fig. 2, in this equivalent circuit of the memory portion of the NAND flash memory, the drain and gate of the first select gate transistor are connected to a bit line BL and the control signal line SG1, respectively. The gate and source of the second select gate transistor are connected to the control signal line SG2 and the memory cell source ARVSS, respectively. In addition, between the first and second select gate transistors, a plurality of memory cell transistors are connected in series such that their control gates are connected in one-to-one correspondence to the word lines WLn (n = 0 to 15).

In the following explanation, the structure in which the first select gate transistor, a plurality of memory cell transistors, and the second select gate transistor are connected in series as shown in Fig. 2 is called a string. In this NAND flash memory, a number of such strings are connected to one bit line.

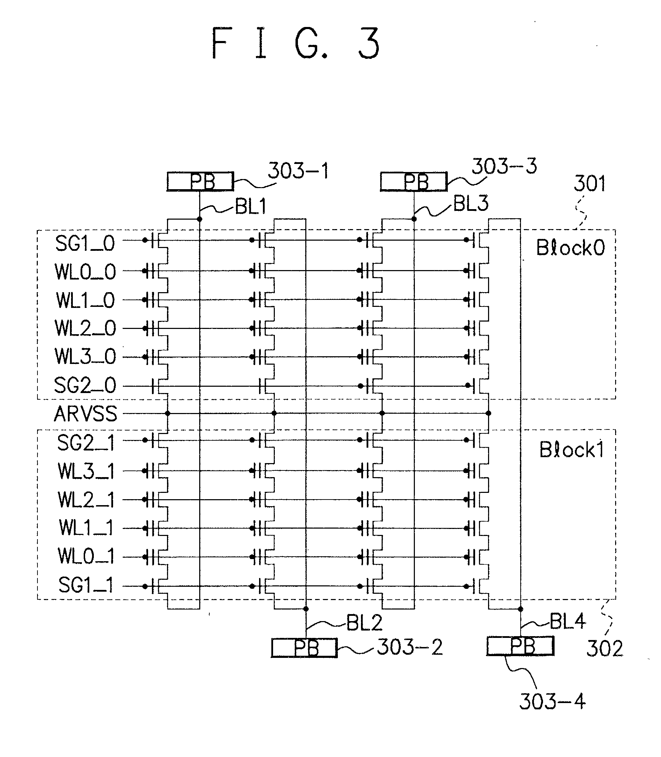

Fig. 3 is a view showing the arrangement of a memory cell array of a NAND flash memory.

Note that Fig. 3 shows a NAND flash memory composed of strings each made up of a first select gate transistor, four memory cell transistors, and a second select gate transistor.

In Fig. 3, reference numeral 301 denotes a first block composed of four strings connected to the memory cell source line ARVSS at one end and to first to fourth bit lines BL1 to BL4 at the other end. Likewise, reference numeral 302 denotes a second block composed of four strings, different from those constructing the first block, connected to the memory cell source line ARVSS at one end and to the first to fourth bit lines BL1 to BL4 at the other end.

Reference numerals 303-1, 303-2, 303-3, and 303-4 denote page buffers connected to the first, second, third, and fourth bit lines BL1, BL2, BL3, and BL4, respectively. These page buffers 303-1 to 303-4 control the potentials of the bit lines BL1 to BL4 in order to write data supplied to memory cell transistors, and output data to the outside on the basis of the potentials of the bit lines BL1 to BL4.

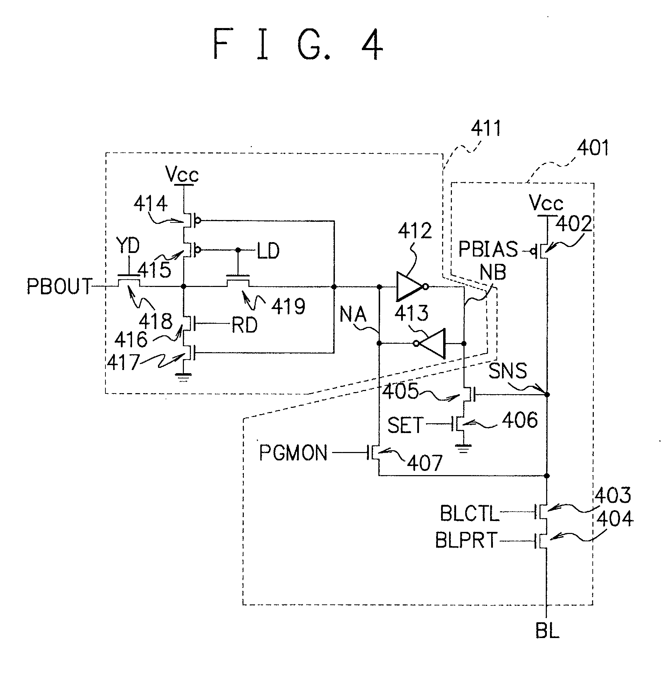

Fig. 4 is a block diagram showing the arrangement of each of the page buffers 303-1 to 303-4 shown in Fig. 3.

Referring to Fig. 4, this page buffer includes a sense amplifier unit 401 and a latch buffer unit 411.

The sense amplifier unit 401 comprises one P-channel MOS transistor (to be referred to as a "Pch-Tr" hereinafter) 402, and five N-channel MOS transistors (to be referred to as "Nch-Tr's" hereinafter) 403, 404, 405, 406, and 407.

A power supply voltage Vcc is supplied to the source of the Pch-Tr 402, and the gate and drain of this Pch-Tr 402 are connected to a signal line PBIAS and the drain of the Nch-Tr 403, respectively. The gate and source of the Nch-Tr 403 are connected to a signal line BLCTL and the drain of the Nch-Tr 404, respectively. The gate and source of this Nch-Tr 404 are connected to a signal line BLPRT and the bit line BL, respectively.

The drain, gate, and source of the Nch-Tr 405 are connected to a node NB (to be described later), an interconnecting point SNS between the drains of the Pch-Tr 402 and the Nch-Tr 403, and the drain of the Nch-Tr 406, respectively. The gate and source of the Nch-Tr 406 are connected to a signal line SET and a ground potential (GND), respectively. The drain, gate, and source of the Nch-Tr 407 are connected to a node NA (to be described later), a signal line PGMON, and an interconnecting point between the drains of the Pch-Tr 402 and the Nch-Tr 403, respectively.

The latch buffer unit 411 comprises two inverters 412 and 413, two Pch-Tr's 414 and 415, and four Nch-Tr's 416, 417, 418, and 419.

The node NA is connected to the input terminal of the inverter 412, and the node NB is connected to the output terminal of the inverter 412. This node NB is also connected to the input terminal of the inverter 413, and the node NA is connected to the output terminal of the inverter 413. That is, these inverters 412 and 413 construct a latch circuit.

The power supply voltage Vcc is supplied to the source of the Pch-Tr 414, and the gate and drain of this Pch-Tr 414 are connected to the node NA and the source of the Pch-Tr 415, respectively. The gate and drain of the Pch-Tr 415 are connected to a signal line LD and the drain of the Nch-Tr 416, respectively. The gate and source of this Nch-Tr 416 are connected to a signal line RD and the drain of the Nch-Tr 417, respectively. The gate and source of the Nch-Tr 417 are connected to the node NA and the ground potential (GND), respectively.

The source, gate, and drain of the Nch-Tr 418 are connected to a signal line PBOUT, a signal line YD, and an interconnecting point between the drains of the Pch-Tr 415 and the Nch-Tr 416, respectively. The source, gate, and drain of the Nch-Tr 419 are connected to an interconnecting point between the drains of the Pch-Tr 415 and the Nch-Tr 416, the signal line LD, and the node NA, respectively.

In data read, "L" (0 V) and "H" (the power supply voltage Vcc, e.g., 3.3 V) are supplied from the signal lines LD and RD, respectively, to turn on the Pch-Tr 415 and the Nch-Tr 416 and turn off the Nch-Tr 419. Accordingly, the Pch-Tr 414 and the Nch-Tr 417 configure an inverter (buffer) to invert the signal at the node NA and supply the inverted signal to the Nch-Tr 418. This Nch-Tr 418 is controlled on the basis of a signal corresponding to an address from which data supplied via the signal line YD is to be read out, and outputs the signal formed by inverting the signal at the node NA via the signal line PBOUT. In this manner, it is possible to prevent the inversion, due to the external wiring capacitance (signal line PBOUT) or the like, of data in the latch circuit composed of the inverters 412 and 413, before this data in the latch circuit is determined. Note that the operation between the bit line BL and the node NA in the latch buffer unit 411 during data read will be described later.

In data write, on the other hand, "H" (the power supply voltage Vcc, e.g., 3.3 V) and "L" (0 V) are supplied from the signal lines LD and RD, respectively, to turn off the Pch-Tr 415 and the Nch-Tr 416 and turn on the Nch-Tr 419. The Nch-Tr418 controlled on the basis of a signal corresponding to an address into which data supplied via the signal line YD is to be written receives data via the signal line PBOUT and supplies this received data to the node NA. Note that the operation between the bit line BL and the node NA in the latch buffer unit 411 during data write will be described later.

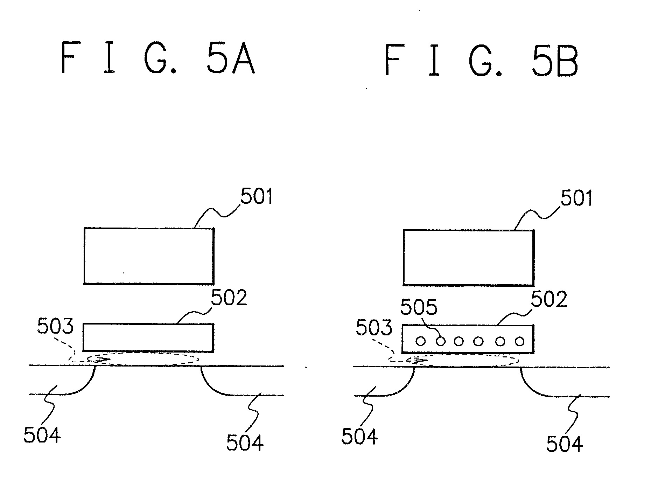

The section of the memory cell transistor and the state of data storage will be described below with reference to Figs. 5A and 5B.

Fig. 5A is a schematic view showing the state of the memory cell transistor when "1" is stored as a data value.

Referring to Fig. 5A, this memory cell transistor is an Nch-Tr having a control gate 501, a floating gate 502, an oxide film (tunnel oxide film) 503, and a diffusion layer 504. When the data value "1" is stored in this memory cell transistor, no electrons are accumulated in the floating gate 502 because they are extracted from it. In this state, a threshold voltage Vₜₕ of this memory cell transistor is negative, so the memory cell transistor functions as a depletion type (normally ON type) transistor.

Fig. 5B is a schematic view showing the state of the memory cell transistor when "0" is stored as a data value.

As shown in Fig. 5B, when the data value "0" is stored in this memory cell transistor, electrons 505 are injected into and accumulated in the floating gate 502. In this state, the threshold voltage Vₜₕ of this memory cell transistor is positive, so the memory cell transistor functions as an enhancement type (normally OFF type) transistor.

A read operation, program (data write) operation, program verify operation, and erase verify operation of the NAND flash memory will be explained in turn.

In the following explanation, assume that in the read operation, program operation, and program verify operation, a memory cell transistor (to be simply referred to as a "memory cell" hereinafter) selected by a word line WL0 is selected. For the sake of convenience, "to supply a certain voltage (a certain voltage level) via a signal line" will be expressed as "to set a signal at a certain voltage (a certain voltage level)" hereinafter.

### (Read Operation)

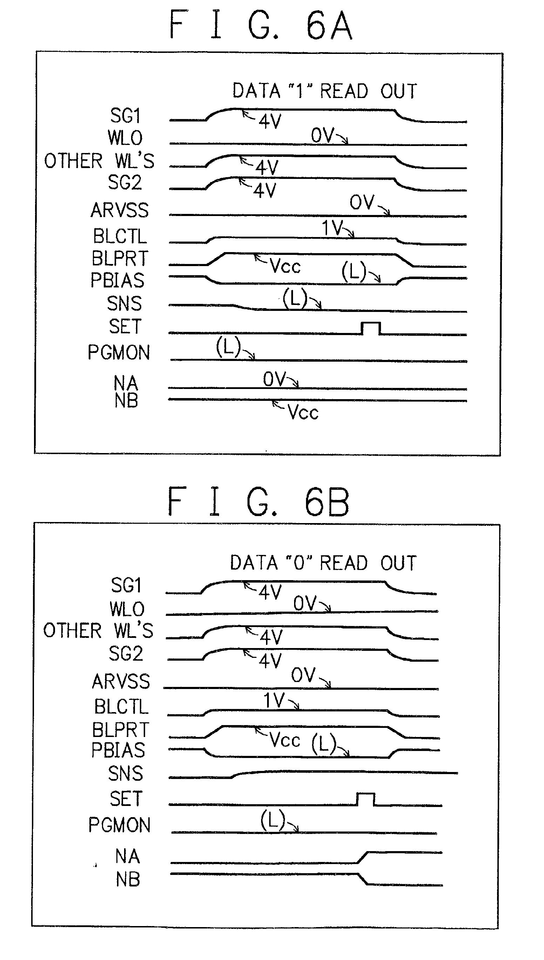

Figs. 6A and 6B are timing charts of the read operation of the NAND flash memory.

To read out the data value of a memory cell selected by the word line WL0, this word line WL0 is set at 0 V, and word lines other than the word line WL0 are set at about 4 V. In addition, the control signals SG1 and SG2 of a string having the memory cell from which the data value is to be read out are set at about 4 V, thereby selecting the string having this memory cell from which the data value is to be read out. Also, the memory cell source line ARVSS is set at 0 V. Consequently, in the string having the memory cell from which the data value is to be read out, memory cells except for the memory cell to be selected by the word line WL0 and the first and second select gate transistors are turned on. Note that the signals SET and PGMON are set at 0 V.

Next, the signals BLCTL and BLPRT are set at HIGH level (to be referred to as "H" hereinafter) to turn on the Nch-Tr's 403 and 404 in the sense amplifier unit 401, thereby making the latch buffer unit 411 and the bit line BL electrically connectable. Also, the signal PBIAS is set at LOW level (to be referred to as "L" hereinafter) to turn on the Pch-Tr 402, supplying an electric current to the bit line BL. This electric current is the reference for checking whether the data value of the memory cell is "1" or "0".

Before the above operation is completed, the nodes NA and NB in the latch buffer unit 411 are set at "L" and "H", respectively.

In this state, if the data value of the memory cell is "1", the threshold voltage Vₜₕ of this memory cell is negative. Therefore, even when the word line WL0 is at 0 V, the memory cell from which the data value is to be read out is turned on, so an electric current flows. This lowers (to "L") the potential at the interconnecting point SNS between the drains of the Pch-Tr 402 and the Nch-Tr 403, both of which are electrically connected to the bit line BL.

After that, the signal SET is pulsed to "H". Since the potential at the interconnecting point SNS is "L", the Nch-Tr 405 is OFF. Hence, even when the signal SET is pulsed to "H", the node NB in the latch buffer unit 411 maintains "H". When the signal SET returns to "L", therefore, the nodes NA and NB in the latch buffer unit 411 are "L" and "H", respectively, so the state in which the data value is "1" is held in the latch circuit (Fig. 6A).

On the other hand, if the data value of the memory cell is "0", the threshold voltage Vₜₕ of this memory cell is positive. In addition, since the word line WL0 is at 0 V, the memory cell from which the data value is to be read out is turned off, so no electric current flows. This raises (charges to "H") the potential at the interconnecting point SNS electrically connected to the bit line BL.

When the signal SET is pulsed to "H" after that, the Nch-Tr 406 is turned on. Since the potential at the interconnecting point SNS is "H", i.e., the Nch-Tr 405 is ON, the node NB in the latch buffer unit 411 is grounded, so this node NB changes to "L". When the signal SET returns to "L", therefore, the nodes NA and NB in the latch buffer unit 411 are "H" and "L", respectively, so the state in which the data value is "0" is held in the latch circuit (Fig. 6B).

When the Nch-Tr 418 is turned on under the control as described above with reference to Fig. 4, the level of the node NA is inverted, so the state held in the latch buffer unit 411 is output as the signal PBOUT.

The signals BLCTL and BLPRT are set at 0 V and PBIAS is set at Vcc to disconnect the electrical connection between the page buffer and the bit line BL. Additionally, all the word lines WLn and the control signals SG1 and SG2 are set at 0 V to select no string, thereby completing the read operation.

### (Program Operation)

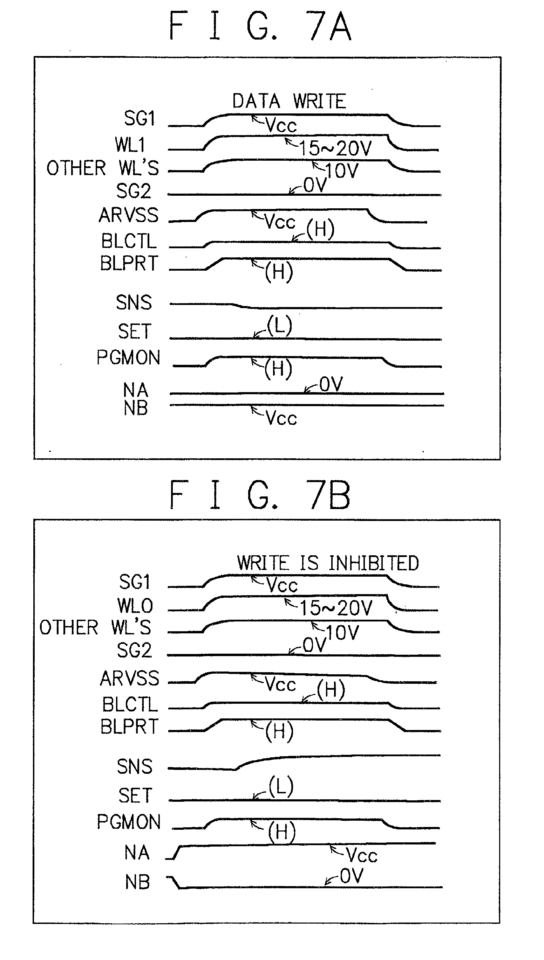

Figs. 7A and 7B are timing charts of the program operation of the NAND flash memory.

A string having a memory cell to be subjected to this program operation is selected by setting the control signals SG1 and SG2 of this string at the power supply voltage Vcc and 0 V, respectively. In this program operation, the memory cell source line ARVSS is set at the power supply voltage Vcc. Note that the signal SET is set at 0 V.

Also, to write data (the data value "0") in the memory cell, control is performed as described above with reference to Fig. 4 to set the nodes NA and NB in the latch buffer unit 411 at "L" and "H", respectively. To inhibit data write to the memory cell (to hold the data value "I"), control is performed as described above with reference to Fig. 4 to set the nodes NA and NB in the latch buffer unit 411 at "H" and "L", respectively.

In this state, the signals BLCTL, BLPRT, and PGMON are changed to "H" to turn on the Nch-Tr's 403, 404, and 407 in the sense amplifier unit 401, thereby making the latch buffer unit 411 and the bit line BL electrically connectable. In addition, the word line WL0 is set at a voltage of 15 to 20 V (e.g., 18 V), and word lines other than this word line WL0 are set at about 10 V.

Accordingly, to write data in the memory cell, the potential at the interconnecting point SNS, i.e., the potential of the bit line BL is set at 0 V ("L") by that voltage level set at the node NA in the latch buffer unit 411, which is supplied via the Nch-Tr 407. Consequently, the control gate of the memory cell into which the data is to be written is set at 15 to 20 V, and the diffusion layer is set at 0 V. This potential difference of 15 to 20 V between the control gate and the diffusion layer injects electrons into the floating gate from the memory cell channel portion, writing a data value "0" in the memory cell (Fig. 7A).

On the other hand, to inhibit data write to the memory cell, the potential at the interconnecting point SNS, i.e., the potential of the bit line BL is set at "H" by that voltage level set at the node NA in the latch buffer unit 411, which is supplied via the Nch-Tr 407. Consequently, a voltage of 15 to 20 V is applied to the control gate of the memory cell selected by the word line WL0. Since, however, the diffusion layer is "H", no electrons are injected into the floating gate from the memory cell channel portion, so no data is written in the memory cell (Fig. 7B).

The signals BLCTL, BLPRT, and PGMON are set at 0 V to disconnect the electrical connection between the bit line BL and the page buffer. Additionally, all the word lines WLn and the control signals SG1 and SG2 are set at 0 V to select no string. Furthermore, the memory cell source line ARVSS is set at 0 V to complete the program operation.

In the above program operation, the memory cell source line is set at the power supply voltage Vcc. However, a voltage lower than this power supply voltage Vcc can also be used if it can prohibit that the voltage levels at the nodes NA and NB of the latch buffer unit 411 can be inverted. This voltage is preferably substantially 1/2 the power supply voltage Vcc or more, and less than the power supply voltage Vcc.

### (Program Verify Operation)

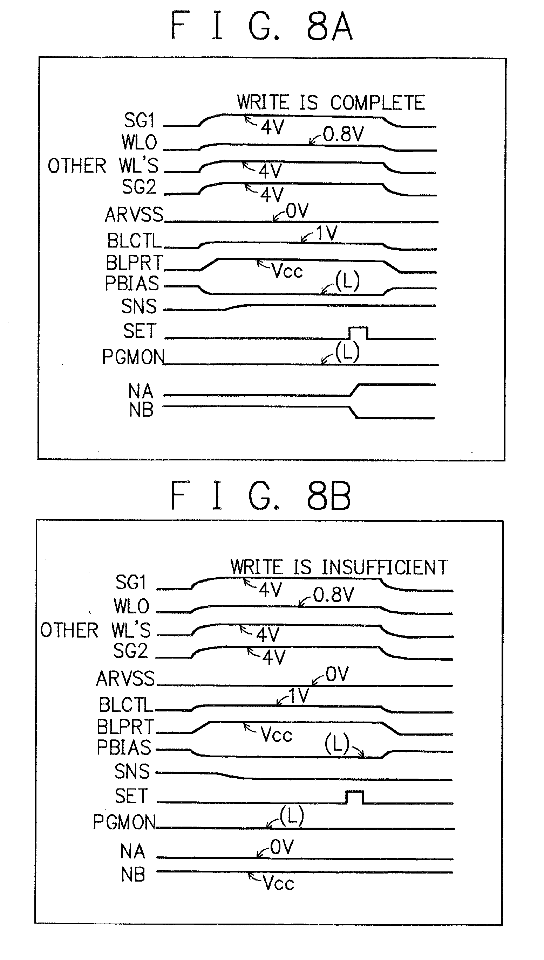

Figs. 8A and 8B are timing charts of the program verify operation of the NAND flash memory. The basic operation of this program verify operation is the same as the read operation described above, except that in the program verify operation the word line WL0 to be selected is set at a certain positive potential. For example, when the word line WL0 is set at 0.8 V, a read margin of 0.8 V can be obtained with respect to the minimum threshold voltage Vₜₕ of a memory cell from which the data value "0" is to be read out in the read operation.

In the program verify operation, the voltage levels at the nodes NA and NB in the latch buffer unit 411 are those of these nodes NA and NB at the end of the program operation. That is, the voltage levels at the nodes NA and NB in the latch buffer unit 411 are "L" and "H", respectively, when data is written in a memory cell, and "H" and "L", respectively, when data write to a memory cell is inhibited.

The condition by which it is determined by the program verify operation that the program operation is normally performed (the memory cell threshold voltage Vₜₕ has a sufficient read margin) is that the nodes NA and NB in the latch buffer unit 411 are "H" and "L", respectively. Additionally, in the NAND flash memory the program verify operation is performed for all memory cells sharing the same word line at the same time. Therefore, when the nodes NA and NB in the latch buffer unit 411 of each of all page buffers are "H" and "L", respectively, it is determined that the program operation is normally done in the NAND flash memory.

First, the word line WL0 is set at 0.8 V, and word lines other than this word line WL0 are set at about 4 V. In addition, the control signals SG1 and SG2 of a string having a memory cell to be subjected to program verify are set at about 4 V, thereby selecting this string having the memory cell to be subjected to program verify. Also, the memory cell source line ARVSS is set at 0 V. Consequently, in the string having the memory cell to be subjected to program verify, memory cells except for this memory cell to be selected by the word line WL0 and the first and second select gate transistors are turned on. Note that the signals SET and PGMON are set at 0 V.

Next, the signals BLCTL and BLPRT are changed to "H" and the signal PBIAS is changed to "L" to turn on the Pch-Tr 402 and the Nch-Tr's 403 and 404 in the sense amplifier unit 401, thereby making the latch buffer unit 411 and the bit line BL electrically connectable and supplying an electric current to the bit line BL. This electric current is the reference for checking whether data (the data value "0") is well written in the memory cell (whether the memory cell has a sufficient read margin).

If the data (data value "0") is well written in the memory cell, the threshold value Vₜₕ of this memory cell is higher than 0.8 V of the word line WL0. Therefore, the memory cell is turned off, so no electric current flows. This raises (charges to "H") the potential at the interconnecting point SNS electrically connected to the bit line BL and turns on the Nch-Tr 405.

When the signal SET is pulsed to "H" after that, the Nch-Tr 406 is turned on to ground the node NB in the latch buffer unit 411, so this node NB changes to "L". Accordingly, when the signal SET returns to "L", the nodes NA and NB in the latch buffer unit 411 change to "H" and "L", respectively. Hence, it is determined that the data is well written in the memory cell (the program operation is normally done) (Fig. 8A).

On the other hand, if the data is not well written in the memory cell, the memory cell threshold value Vₜₕ is lower than 0.8 V of the word line WL0. Therefore, the memory cell is turned on, and an electric current flows. This lowers (to "L") the potential at the interconnecting point SNS electrically connected to the bit line BL.

After that, the signal SET is pulsed to "H". Since the potential at the interconnecting point SNS is "L", the Nch-Tr 405 is OFF. Hence, even if the signal SET is pulsed to "H", the node NB in the latch buffer unit 411 maintains "H". When the signal SET returns to "L", therefore, the nodes NA and NB in the latch buffer unit 411 are still "L" and "H", respectively, so it is determined that the data is not well written in the memory cell, i.e., the program operation failed (Fig. 8B).

The signals BLCTL and BLPRT are set at 0 V and PBIAS is set at Vcc to disconnect the electrical connection between the page buffer and the bit line BL. Additionally, all the word lines WLn and the control signals SG1 and SG2 are set at 0 V to select no string, thereby completing the program verify operation.

If it is determined that the data is not well written in the memory cell as described above, this program verify operation is terminated. After that, the program operation and the program verify operation are repeatedly performed for the memory cell until it is determined that the data is well written in the memory cell.

Also, although not shown, in the program operation the threshold voltage Vₜₕ of a memory cell to which no data write is permitted is lower than 0.8 V of the word line WL0, so this memory cell is turned on to allow an electric current to flow. Since this lowers the potential at the interconnecting point SNS, i.e., the potential of the bit line BL, the Nch-Tr 405 is turned off. Therefore, even when the signal SET is pulsed to "H" and then returned to "L", the nodes NA and NB in the latch buffer unit 411 maintain "H" and "L", respectively. Accordingly, it is determined that the program operation is normally performed, so the program verify operation is completed.

The program operation and the program verify operation performed for a memory cell connected to a bit line rendered defective by that short circuit between the bit line BL and the memory cell source line ARVSS, which readily occurs in the fabrication process because the memory cell source line ARVSS made of a metal is formed to run parallel to the bit line BL as described earlier, will be explained below.

Since a memory cell connected to a bit line found to be defective is not generally used, data write to this memory cell is inhibited in the program operation. That is, the program operation is performed by setting the nodes NA and NB in the latch buffer unit 411 at "H" and "L", respectively.

Similar to the program operation described previously, a string having a memory cell to be subjected to a program operation is selected, and the memory cell source line ARVSS is set at the power supply voltage Vcc. Note that the signal SET is set at 0 V.

In this state, the signals BLCTL, BLPRT, and PGMON are changed to "H" to make the latch buffer unit 411 and the bit line BL electrically connectable. Since the nodes NA and NB in the latch buffer unit 411 are "H" and "L", respectively, and the memory cell source line ARVSS short-circuited to the bit line BL is "H" (the power supply voltage Vcc), the potential at the interconnecting point SNS, i.e., the potential of the bit line BL changes to "H".

After that, a program operation similar to that when data write to a memory cell is inhibited as shown in Fig. 7B is performed.

In the program verify operation when the bit line BL and the memory cell source line ARVSS are short-circuited, the potential of the bit line BL, i.e., the potential at the interconnecting point SNS is "L" regardless of data in a memory cell, because the bit line BL and the memory cell source line ARVSS are short-circuited. This turns off the Nch-Tr 405 whose gate is connected to the interconnecting point SNS. When the signal SET is pulsed to "H" and then returned to "L", therefore, the nodes NA and NB in the latch buffer circuit 411 maintain "H" and "L", respectively. Accordingly, it is determined that the program operation is normally done, so this program verify operation is completed.

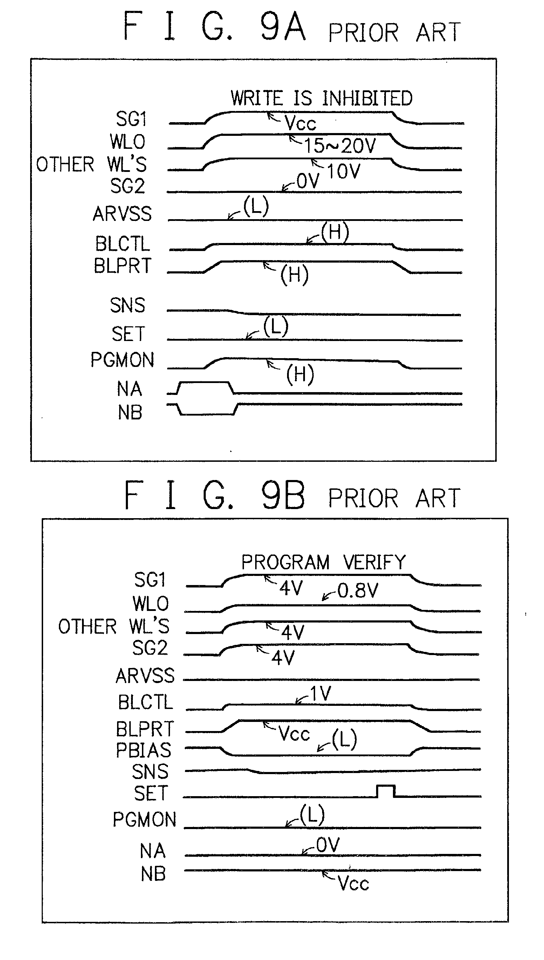

In contrast, in a program operation of a memory cell connected to a bit line rendered defective by a short circuit between the bit line BL and the memory cell source line ARVSS in a conventional NAND flash memory, as shown in Fig. 9A, the voltage levels at the nodes NA and NB in the latch buffer circuit 411 change for the reason explained below. That is, the memory cell source line ARVSS short-circuited to the bit line BL is "L". When the latch buffer unit 411 and the bit line BL are electrically connected, therefore, the potential at the interconnecting point SNS changes to "L", so the node NA in the latch buffer unit 411 connected to this interconnecting point SNS via the Nch-Tr 407 changes from "H" to "L".

Additionally, when the program verify operation is performed with the nodes NA and NB in the latch buffer unit 411 at "L" and "H", respectively, as shown in Fig. 9B, the potential of the bit line BL, i.e., the potential at the interconnecting point SNS changes to "L" regardless of data in a memory cell, because the bit line BL and the memory cell source line ARVSS are short-circuited. Therefore, when the signal SET is pulsed to "H" and then returned to "L", the nodes NA and NB in the latch buffer unit 411 maintain "L" and "H", respectively. Accordingly, it is determined that the program operation is not normally performed, so a program operation is executed again after this program verify operation is terminated.

If, however, the bit line BL and the memory cell source line ARVSS are short-circuited, the program operation changes the nodes NA and NB in the latch buffer unit 411 to "L" and "H", respectively, and the program verify operation holds this state. Consequently, the program verify operation never determines that the program operation is normally done, so program and program verify operations are repetitively performed.

In the program operation according to this embodiment, on the other hand, the memory cell source line ARVSS is set at the power supply voltage Vcc in the period during which the program operation is performed. Therefore, the potential of the bit line BL is kept "H" if this bit line BL and the memory cell source line ARVSS are short-circuited. Consequently, a program verify operation performed after the program operation determines that the program operation is normally done, so this program verify operation can be terminated.

### (Erase Verify Operation)

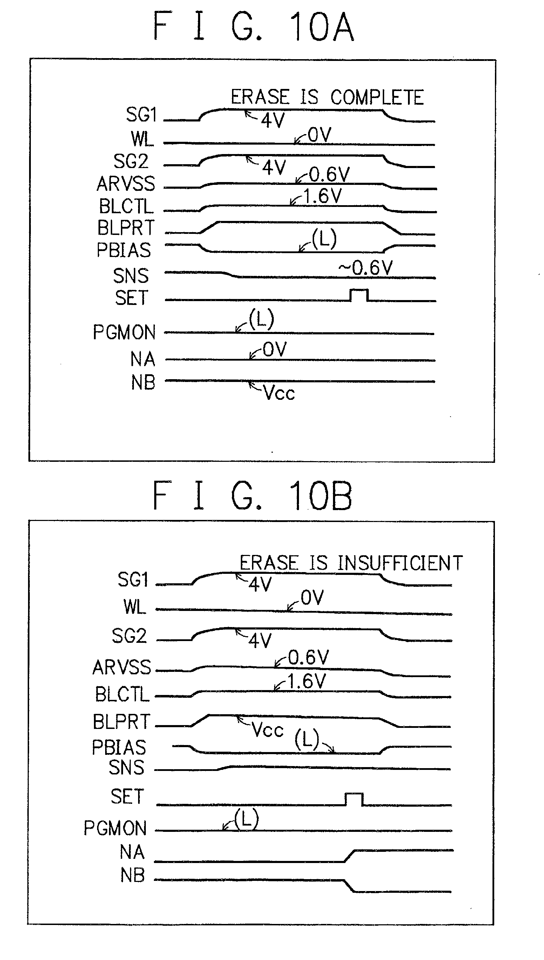

Figs. 10A and 10B are timing charts of the erase verify operation of the NAND flash memory. The basic operation of this erase verify operation is the same as the read operation described earlier, except that this erase verify operation is performed in a selected block (erase unit). That is, all the word lines WLn in this block are set at 0 V, and the memory cell source line ARVSS is set at a certain positive potential. In this way, the potential of the control gate with respect to the source of a memory cell is equivalently set at a negative potential, thereby ensuring the threshold voltage Vₜₕ of this memory cell. For example, when the memory cell source line ARVSS is set at 0.6 V, a read margin of 0.6 V can be obtained with respect to the minimum threshold voltage Vₜₕ (absolute value) of a memory cell from which the data value "1" is to be read out in the read operation.

In this erase verify operation, the condition by which it is determined that data in a memory cell is normally erased is that the nodes NA and NB in the latch buffer circuit 411 are "L" and "H", respectively.

In the erase verify operation, all the word lines WLn in a selected block are set at 0 V, and the control signals SG1 and SG2 of a string included in the block are set at about 4 V. Also, the memory cell source line ARVSS is set at 0.6 V. Note that the signals SET and PGMON are set at 0 V.

Next, the signals BLCTL and BLPRT are changed to "H" and the signal PBIAS is changed to "L" to turn on the Pch-Tr 402 and the Nch-Tr's 403 and 404 in the sense amplifier 401, thereby making the latch buffer unit 411 and the bit line BL electrically connectable and supplying an electrical current to the bit line BL. This electric current is the reference for checking whether data in a memory cell is well erased.

Note that in the above-mentioned read operation, program operation, and program verify operation, the signal BLCTL is set at about 1 V. In this erase verify operation, however, the signal BLCTL is set at about 1.6 V (when the memory cell source line ARVSS is 0.6 V). This is to supply a sufficient drain-source voltage to each of a plurality of memory cells in the string.

Before the above operation is completed, the nodes NA and NB in the latch buffer circuit 411 are set at "L" and "H", respectively.

If data in a memory cell is well erased, the threshold voltage Vₜₕ of this memory cell is lower than a potential difference of -0.6 V of the word line WLn from the memory cell source line ARVSS. Therefore, the memory cell is turned on, and an electric current flows. This lowers (to "L") the potential at the interconnecting point SNS electrically connected to the bit line BL.

When the signal SET is pulsed to "H" and then returned to "L" after that, the nodes NA and NB in the latch buffer unit 411 maintain "L" and "H", respectively, so it is determined that the data in the memory cell is normally erased (Fig. 10A).

The signals BLCTL and BLPRT are set at 0 V and PBIAS is set at Vcc to disconnect the electrical connection between the page buffer and the bit line BL, and the control signals SG1 and SG2 are set at 0 V to select no string. In addition, the memory cell source line ARVSS is set at 0 V to complete this erase verify operation.

On the other hand, if the data in the memory cell is not well erased, the threshold voltage Vₜₕ of this memory cell is higher than the potential difference of -0.6 V of the word line WLn from the memory cell source line ARVSS. Therefore, the memory cell is turned off, and no electric current flows. This raises (charges to "H") the potential at the interconnecting point SNS electrically connected to the bit line BL, and turns on the Nch-Tr 405.

When the signal SET is pulsed to "H" after that, the Nch-Tr 406 is turned on to ground the node NB in the latch buffer unit 411, so this node NB changes to "L". Therefore, when the signal SET returns to "L", the nodes NA and NB in the latch buffer unit 411 change to "H" and "L", respectively. Consequently, it is determined that the data in the memory cell is not normally erased, i.e., the erase operation is unsatisfactory (Fig. 10B).

If it is thus determined that the erase operation is not well performed, after this erase verify operation is completed as described above, erase operation and erase verify operations are executed again. Note that the erase operation is performed by setting all the word lines WLn in a selected block at 0 V, supplying about 20 V to a well in which a memory cell is formed, and extracting electrons into this well from the floating gate of the memory cell.

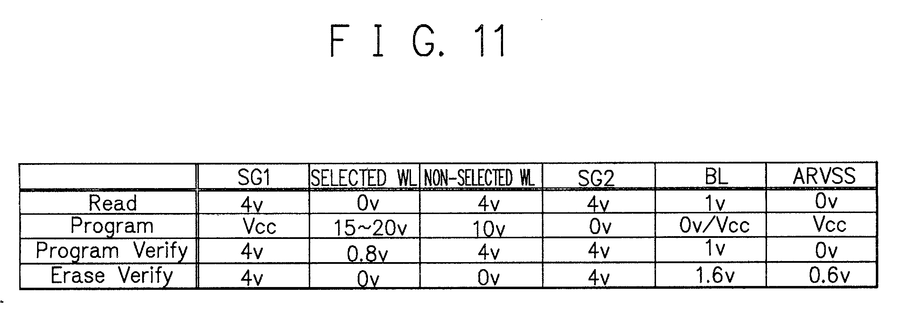

Fig. 11 shows examples of voltages supplied via the control signal lines SG1 and SG2, the word lines WL (a selected word line and non-selected word lines), and the memory cell source line ARVSS, and the corresponding voltages of the bit line BL, in the read operation, program operation, program verify operation, and erase verify operation described above.

In this embodiment as has been explained in detail above, in the program operation in which data write to a memory cell is performed, a positive voltage (a voltage which is in the range of approximately 1/2 of the power supply voltage Vcc to the power supply voltage Vcc) is supplied to the memory cell source line ARVSS at least during the period in which the signal PGMON for electrically connecting the node NA in the latch buffer unit 411 and the bit line BL is set at "H".

Accordingly, even if the bit line BL and the memory cell source line ARVSS are short-circuited, at least during the period in which the signal PGMON is "H" it is possible to maintain the node NA at "H" by setting the potential of the bit line BL and the node NA connected to this bit line BL at a certain potential (a voltage which is in the range of approximately 1/2 of the power supply voltage Vcc to the power supply voltage Vcc). Therefore, in the program verify operation performed after the program operation, it is possible to determine that the program operation is normally done, and to complete the program verify operation. Consequently, a defect caused by a short circuit between a bit line and a memory cell source line can be repaired by using a redundancy circuit.

The above embodiment indicates only one practical example in practicing the present invention, so the technical scope of the invention should not be limitedly interpreted by this embodiment. That is, the present invention can be carried out in various forms without departing from the technical thought or the principal features of the invention.

In the present invention as described above, the potential of a line for supplying a reference potenti al to a memory cell for storing data is set at a positive potential during a period in which data write to the memory cell is performed.

Accordingly, even if a bit line for inputting and outputting data to and from the memory cell and the line for supplying the reference potential to the memory cell are short-circuited, it is possible to suppress fluctuations in the potential of the bit line during the data write, and to complete a verify operation performed after the data write. This makes it possible to repair a defect caused by a short circuit between the bit line and the line for supplying the reference potential. Consequently, the yield (the number of products which can be shipped with respect to the number of all products) in the semiconductor memory fabrication process can be improved.

## Claims

1. A semiconductor memory comprising:
a memory cell comprising a transistor having a control gate and a floating gate to store data;
a line for supplying a reference potential to said memory cell; and
means for supplying said reference potential to said line,
wherein during a period in which a data write operation to said memory cell is performed, a potential of said line for supplying the reference potential to said memory cell is set at a positive potential.

2. The memory according to claim 1, wherein the positive potential is not more than a power supply voltage of said semiconductor memory and not less than 1/2 the power supply voltage.

3. The memory according to claim 1 or 2, wherein during a period in which a program verify operation for checking data written by the data write operation is performed, the potential of said line for supplying the reference potential to said memory cell is set at 0 V.

4. The memory according to claim 1, 2 or 3, wherein the positive potential is the power supply voltage of said semiconductor memory.

5. The memory according to claim 1, 2 or 3, wherein the positive potential is substantially 1/2 the power supply voltage of said semiconductor memory.

6. The memory according to any of the preceding claims, wherein a plurality of said memory cells are connected in series, one end of the series-connected memory cells is connected to a bit line for inputting and outputting data to and from said memory cells, and the other end of the series-connected memory cells is connected to said line for supplying the reference potential to said memory cells.

7. The memory according to claim 6, wherein during a period in which a potential of said bit line is set at a potential corresponding to write data to said memory cells, the potential of said line for supplying the reference potential to said memory cells is set at a positive potential.

8. The memory according to claim 7, wherein the positive potential is not more than a power supply voltage of said semiconductor memory and not less than 1/2 the power supply voltage.

9. The memory according to claim 7 or 8, wherein during a period in which a program verify operation for checking data written by the data write operation is performed, the potential of said line for supplying the reference potential to said memory cells is set at 0 V.

10. A method of driving a semiconductor memory which stores data in a memory cell comprising a transistor having a control gate and a floating gate,
the method comprising supplying a positive potential to a line for supplying a reference potential to the memory cell during a period in which a data write operation to the memory cell is performed.

11. The method according to claim 10, wherein the positive potential is not more than a power supply voltage of the semiconductor memory and not less than 1/2 the power supply voltage.

12. The method according to claim 10 or 11, wherein during a period in which a program verify operation for checking data written by the data write operation is performed, 0 V is supplied to the line for supplying the reference potential to the memory cell.

13. A method of driving a semiconductor memory which stores data in a memory cell comprising a transistor having a control gate and a floating gate, and in which a plurality of the memory cells are connected in series, one end of the series-connected memory cells is connected to a bit line for inputting and outputting data to and from the memory cells, and the other end of the series-connected memory cells is connected to a line for supplying a reference potential to the memory cells,
the method comprising supplying a positive potential to said line for supplying the reference potential to the memory cells during a period in which a potential of the bit line is set at a potential corresponding to write data to the memory cells.

14. The method according to claim 13, wherein the positive potential is not more than a power supply voltage of the semiconductor memory and not less than 1/2 the power supply voltage.

15. The method according to claim 13 or 14, wherein during a period in which a program verify operation for checking data written by the data write operation is performed, 0 V is supplied to the line for supplying the reference potential to the memory cells.
